(19) Europäisches Patentamt / European Patent Office / Office européen des brevets

(11) **EP 4 601 416 A1**

(12) **DEMANDE DE BREVET EUROPEEN**

(43) Date de publication:
**13.08.2025 Bulletin 2025/33**

(21) Numéro de dépôt: **24305218.0**

(22) Date de dépôt: **09.02.2024**

(51) Classification Internationale des Brevets (IPC):
**H05B 45/37** (2020.01)   **H05B 45/48** (2020.01)

(52) Classification Coopérative des Brevets (CPC):
**H05B 45/37; H01L 25/167; H05B 45/34; H05B 45/48;** H05B 45/54; H05B 45/59; H05B 47/172; H05B 47/24

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(71) Demandeur: **MCSMBS**
**75020 Paris (FR)**

(72) Inventeurs:
- **KRESS, Samuel**
  **10247 Berlin (DE)**
- **LECLERC, Alexandre**
  **76000 Rouen (FR)**
- **FEVE, Claude**
  **41210 Neung sur Beuvron (FR)**
- **MILLET, Maxime**
  **61560 Bazoches sur Hoene (FR)**

(74) Mandataire: **Loyer & Abello**
**9, rue Anatole de la Forge**
**75017 Paris (FR)**

(54) **DISPOSITIF D'ÉCLAIRAGE POUR UN LOCAL EXPOSÉ À UN RAYONNEMENT IONISANT**

(57) [L'invention concerne un dispositif d'éclairage pour éclairer un local exposé à un rayonnement ionisant, comportant :

un circuit d'alimentation présentant une entrée pour recevoir un courant alternatif d'un réseau électrique secteur et une sortie adaptée à délivrer un courant continu en réponse à la réception du courant alternatif, le circuit d'alimentation comprenant un pont de diodes, et un circuit d'éclairage (50) connecté à la sortie du circuit d'alimentation, le circuit d'éclairage comportant : une pluralité de diodes électroluminescentes (51) montées en série,

une pluralité de diodes Zener (52) montées chacune en parallèle d'une ou plusieurs diodes électroluminescentes de la pluralité de diodes électroluminescentes et au moins une résistance (53) montée en série avec la pluralité de diodes électroluminescentes, dans lequel une tension d'alimentation nominale cumulative de la pluralité de diodes électroluminescentes montées en série est adaptée à une tension nominale du réseau électrique secteur.

[Fig. 6]

EP 4 601 416 A1

## Description

### Domaine technique

L'invention se rapporte au domaine des dispositifs d'éclairage pour éclairer un local exposé à un rayonnement ionisant.

### Arrière-plan technologique

Dans l'état de la technique, il est connu plusieurs types d'éclairage destinés à être utilisés dans un local exposé à un rayonnement ionisant.

On connaît notamment des dispositifs d'éclairage comprenant un circuit d'alimentation adapté à recevoir en entrée un courant alternatif d'un réseau électrique secteur et un circuit d'éclairage adapté à être alimenté par ledit circuit d'alimentation et comprenant une pluralité de diodes électroluminescentes.

Cependant, les circuits électriques de ces dispositifs d'éclairage connus de l'état de la technique comprennent un ou plusieurs composant électrique peu résistant aux rayonnements ionisants, tels qu'un transformateur abaisseur de tension ou un circuit intégré (un transistor ou un amplificateur opérationnel). Par exemple, CN-A-114143932 emploie des puces SM2315 qui sont des circuits intégrés contenant, dans un espace réduit, plusieurs transistors Mosfet et des amplificateurs opérationnels qui fonctionnent comme comparateurs. Par exemple, CN-A-112867197 emploie un transformateur abaisseur de tension et des transistors, ainsi que des condensateurs électrolytiques. Un tel transformateur abaisseur de tension emploie des enroulements dont les spires sont isolées l'une de l'autre par un isolant, tel que l'émail qui recouvre les fils. L'action des rayonnements ionisants est susceptible d'endommager l'isolant et de créer des courts-circuits entre les spires, d'autant plus rapidement que les épaisseurs d'isolant sont fines. CN-A-109219183 emploie également un transformateur abaisseur de tension. Dans le cas d'un tel transformateur, le court-circuit entraîne la fin de vie du composant et peut même causer un départ de feu.

Ces composants électriques ne sont capables de résister qu'à une faible dose de rayonnement ionisant sans dégradation de leur fonctionnement.

La durée d'utilisation de ces dispositifs d'éclairage dans un local exposé à un rayonnement ionisant, avec un fonctionnement fiable, risque en conséquence d'être très limitée.

### Résumé

Une idée à la base de l'invention est de fournir un dispositif d'éclairage pour éclairer un local exposé à un rayonnement ionisant présentant une résistance accrue au rayonnement ionisant et en conséquence une durée d'utilisation soumise à un rayonnement ionisant allongée.

En préambule, on notera les définitions qui suivent.

La valeur nominale d'une grandeur électrique relative à un composant électrique particulier est une valeur théorique ou, en d'autres termes, une valeur idéale, de la grandeur électrique pour laquelle le fonctionnement du composant électrique est optimisé. Dans le cas des composants électriques, les valeurs nominales de certaines grandeurs électriques sont indiquées par le fabriquant et souvent inscrites par celui-ci sur le composant électrique.

La tension nominale Unom d'un équipement électrique est la différence de potentiel théorique pour laquelle un équipement électrique est conçu. Cette tension nominale garantit un fonctionnement satisfaisant de l'équipement électrique, par exemple un rendement optimal. L'adjectif « nominale » indique que cette tension sert généralement à caractériser l'équipement.

Dans le cas d'un réseau électrique du type secteur, appelé dans la suite réseau électrique secteur ou réseau secteur, fournissant une tension secteur, la tension nominale du réseau électrique, aussi appelée dans la suite tension secteur nominale, est celle utilisée pour dénommer ou identifier le réseau. En pratique, les fournisseurs d'électricité fournissent une tension secteur comprise dans une plage autour de cette valeur de tension secteur nominale.

La valeur efficace Ueff d'une tension variable dans le temps est égale à la valeur de la tension continue qui générerait la même énergie thermique dans le même conducteur ohmique pendant le même temps que cette tension variable. Pour une tension alternative ayant une variation sinusoïdale dans le temps, la valeur efficace Ueff est égale à

Umax/$\sqrt{(2)}$, où Umax est la valeur maximale de la tension variable pendant la variation sinusoïdale. Dans la suite, la valeur maximale de la tension variable pendant la variation sinusoïdale Umax sera appelée la tension de crête.

L'invention concerne ainsi un dispositif d'éclairage pour éclairer un local exposé à un rayonnement ionisant, comportant :

au moins une carte de support,

un circuit d'alimentation monté sur la au moins une carte de support, le circuit d'alimentation présentant une entrée pour recevoir un courant alternatif d'un réseau électrique secteur et une sortie adaptée à délivrer un courant continu en réponse à la réception du courant alternatif, le circuit d'alimentation comprenant un pont de diodes, et un circuit d'éclairage monté sur la au moins une carte de support et connecté à la sortie du circuit d'alimentation, le circuit d'éclairage comportant : une pluralité de diodes électroluminescentes montées en série, une pluralité de diodes Zener montées chacune en parallèle d'une ou plusieurs diodes électroluminescentes de la pluralité de diodes électroluminescentes et au moins une résistance montée en série avec la pluralité de diodes électroluminescentes, dans lequel une tension d'alimentation nominale cumulative de la pluralité de diodes électroluminescentes montées en série est adaptée à une tension nominale du réseau électrique secteur.

On entend par « tension d'alimentation nominale cumulative » de la pluralité de diodes électroluminescentes la somme des tensions directes nominales des diodes électroluminescentes montées en série dans le circuit d'éclairage. La tension directe nominale d'une diode électroluminescente est aussi connue sous la dénomination « forward voltage » et est disponible auprès du fabricant.

Du fait que les diodes électroluminescentes montées en série ont une tension d'alimentation nominale cumulative adaptée à la tension secteur nominale du réseau électrique secteur, le circuit d'alimentation peut être conçu comme un circuit redresseur sans produire une réduction substantielle de la tension, ce qui permet de se passer de tout transformateur de tension.

Selon un mode de réalisation, la tension d'alimentation nominale cumulative de la pluralité de diodes électroluminescentes est supérieure ou égale à 80 % de la tension efficace nominale du réseau électrique secteur, de préférence supérieure ou égale à 90% de la tension efficace nominale du réseau électrique secteur.

De préférence, la tension d'alimentation nominale cumulative de la pluralité de diodes électroluminescentes est inférieure ou égale à 120 % de la tension efficace nominale du réseau électrique secteur, de préférence inférieure ou égale à 100% de la tension efficace nominale du réseau électrique secteur.

De préférence, le circuit d'éclairage est uniquement constitué de : la pluralité de diodes électroluminescentes montées en série, la pluralité de diodes Zener montées chacune en parallèle d'une ou plusieurs diodes électroluminescentes de la pluralité de diodes électroluminescentes et la au moins une résistance montée en série avec la pluralité de diodes électroluminescentes.

Ainsi, le circuit d'éclairage du dispositif d'éclairage ne comporte qu'un minimum de composants électriques. Les composants électriques utilisés sont simples et peuvent être sélectionnés pour présenter une résistance aux rayonnements ionisants optimisée.

Grâce à l'invention, un dispositif d'éclairage présentant une résistance améliorée aux rayonnement ionisants peut être obtenu de manière économique, en utilisant des composants électriques commerciaux.

Selon un mode de réalisation, le courant continu délivré par ledit circuit d'alimentation est un courant continu pulsé qui présente une tension de crête comprise entre 85 et 100% d'une tension de crête du réseau électrique secteur délivrant le courant alternatif reçu en entrée du circuit d'alimentation.

Ainsi, dans le circuit d'alimentation, aucun transformateur de tension n'est utilisé pour diminuer la tension d'alimentation reçue par le circuit d'éclairage.

Selon un mode de réalisation, le circuit d'alimentation est destiné à être connecté à un réseau électrique secteur monophasé présentant une tension efficace nominale supérieure à 110VAC, par exemple égale à 230 VAC.

Ainsi le dispositif d'éclairage est adapté à être alimenté par un réseau secteur monophasé standard disponible dans la plupart des pays.

Pour rappel, en Europe, la tension du réseau secteur monophasé est généralement de 230 VAC 50 HZ. Pour beaucoup de pays dans le monde, elle est comprise entre 220 VAC à 240 VAC, généralement à 50 Hz, parfois 60 Hz. Dans de nombreux pays du continent américain et dans d'autres pays, la tension du réseau secteur monophasée est de 110 à 127 VAC, à 60 HZ, ou 50 Hz. Au Japon, elle est de 100 VAC, 60 Hz ou 50Hz.

Selon un mode de réalisation, le circuit d'alimentation et le circuit d'éclairage sont adaptés à résister sans perte de fonctionnalité à une dose de rayonnement ionisant supérieure ou égale à 8,8 kiloGray (kGy), de préférence supérieure à 10 kGy, de préférence supérieure à 20 kGy, de préférence supérieure à 50 kGy, de préférence supérieure à 100 kGy et de préférence supérieure à 250 kGy.

Ainsi, avantageusement, le dispositif d'éclairage selon l'invention pourra être utilisé pendant au moins dix ans dans des locaux exposés à des rayonnements ionisants d'intensité élevée, par exemple dans un bâtiment réacteur d'une centrale nucléaire, voire plusieurs décennies dans des locaux moins fortement exposés.

Selon un mode de réalisation, ledit circuit d'alimentation est uniquement constitué du pont de diodes et d'un ou plusieurs composants électriques sélectionnés parmi : un fusible, et une ou des résistances. Ainsi, la résistance aux rayonnements ionisants du circuit d'alimentation est optimisée.

Selon un autre mode de réalisation, le circuit d'alimentation est uniquement constitué du pont de diodes et d'un ou plusieurs composants électriques sélectionnés parmi : un fusible, des résistances et des condensateurs.

Les condensateurs du circuit d'alimentation, lorsqu'ils sont présents , sont choisis parmi les types de condensateurs suivants : condensateurs à isolant plastique, notamment à film en polypropylène métallisé, condensateurs à film en polyester métallisé, ou autres, à l'exclusion des condensateurs électrolytiques.

Les résistances du circuit d'alimentation sont par exemple choisies parmi les résistances anti-surtension à film métallique (résistance à « Metal Electrode Leadless Face » ou MELF) ou à film de carbone, et les résistances à couches épaisses, par exemple parmi les « High Pulse Load Carbon Film MELF Resistors », « Pulse Proof in MELF », et « High Power Thick Film Chip Resistors in 1206 case ».

Une diode Transil est de préférence disposée après le pont de diode, en parallèle de celui-ci. Cette diode de suppression de tensions transitoires est adaptée à protéger les composants électroniques sensibles des surtensions rapides transitoires induites par exemple par la foudre ou d'autres évènements. Cette diode de suppression de tensions transitoires comporte par exemple une jonction p-n passivée au verre (GPP) disposée dans une enveloppe en matériau plastique ou en verre. De telles diodes sont par exemple commercialisées par la société SMC.

Selon un mode de réalisation, ledit circuit d'alimentation comprend un circuit de protection contre les surtensions, le circuit de protection contre les surtensions étant uniquement constitué d'un ou plusieurs composants électriques sélectionnés parmi : une ou des bobines de fil conducteur, un ou plusieurs condensateurs, et une ou plusieurs varistances. Ainsi, la résistance aux rayonnements ionisants du circuit d'alimentation est optimisée tout en intégrant une protection contre les surtensions.

Les varistances du circuit de protection contre les surtensions sont choisies par exemple parmi les varistances à oxyde métallique encapsulé dans une enveloppe en résine epoxy. Il s'agit de varistances disque à sorties radiales. Des varistances sont par exemple disposées en amont et en aval de la ou des bobines de fil conducteur. Elles ont pour rôle de protéger le circuit contre des surtensions élevées. Elles présentent un courant de surtension de crête nominal élevé et une capacité d'absorption d'énergie élevée.

Les bobines du circuit de protection contre les surtensions sont choisies par exemple parmi les selfs de mode commun. Ces selfs de modes communs comprennent par exemple deux bobines qui sont séparées par un isolant. En cas de dégradation de la gaine isolant du fil conducteur enroulé pour former l'une des bobines, les performances des selfs sont réduites, mais les selfs restent fonctionnelles et fiables. Il s'agit par exemple de bobines conçues avec des noyaux en ferrite à haute perméabilité. Elles présentent une inductance élevée. Chaque self de mode commun comprend deux bobines qui sont isolées l'une de l'autre. Ces bobines sont utiles pour la protection contre les surtensions transitoires rapides et élevées en combinaison avec les varistances et les diodes de suppression de tension transitoire décrites précédemment.

Selon un mode de réalisation, ledit circuit d'alimentation comprend, en aval du pont de diode, un ou plusieurs condensateurs, et/ou une ou plusieurs résistance et/ou une diode Transil. De préférence, le circuit d'alimentation ne comprend aucun autre composant en aval du pont de diodes.

Selon un mode de réalisation, la au moins une carte de support est une carte de circuit imprimé comportant une couche de matériau conducteur électrique et une structure porteuse, dans laquelle la structure porteuse est réalisée dans un ou plusieurs matériaux choisis parmi : aluminium, cuivre, composite de résine époxyde renforcé en fibre de verre, résine epoxy, céramique.

Selon un mode de réalisation, une dite diode électroluminescente de ladite pluralité de diodes électroluminescentes, c'est-à-dire une, chaque, toutes les ou certaines des diode(s) électroluminescente(s) de ladite pluralité de diodes électroluminescentes, comprend un élément semi-conducteur et un luminophore, non recouverts d'une lentille optique. Ainsi, la résistance aux rayonnements ionisants de la diode électroluminescente est optimisée car l'opacification ou l'assombrissement de la lentille optique est évité.

La taille de l'élément semi-conducteur de la diode électroluminescente lui permet de résister de manière satisfaisante aux rayonnements ionisants.

Selon un mode de réalisation, une dite diode électroluminescente de ladite pluralité de diodes électroluminescentes, c'est-à-dire une, chaque, toutes les ou certaines des diode(s) électroluminescente(s) de ladite pluralité de diodes électroluminescentes, présente une tension d'alimentation directe nominale supérieure à 2V, de préférence comprise entre 2,7 V et 3V pour un courant de 200 mA. En fin de vie de la diode électroluminescente, la tension directe peut atteindre une valeur plus haute.

Selon un mode de réalisation, convenant par exemple pour une tension efficace secteur de 230V, le circuit d'éclairage comporte plus de 50 diodes électroluminescentes, de préférence plus de 60 diodes électroluminescentes, de préférence plus de 70 diodes électroluminescentes.

Ainsi, il est possible d'alimenter le circuit d'éclairage avec le courant continu pulsé délivré en sortie du circuit d'alimentation, ce courant continu pulsé présentant une tension de crête comprise entre 85 et 100% de la tension de crête du réseau secteur fournissant le courant alternatif reçu en entrée du module d'alimentation.

Selon un mode de réalisation, une dite diode Zener, c'est-à-dire une, chaque, toutes les ou certaines des diode(s) Zener, est du type comprenant un boîtier en verre inorganique, sans utilisation de matériau plastique, polymère ou silicone. Ainsi, la résistance aux rayonnements ionisants de la diode Zener est optimisé car la dégradation de son boîtier est limitée.

Selon un mode de réalisation, une dite diode Zener, ou chaque ou certaines des diode(s) Zener, est connectée directement en parallèle à une dite diode électroluminescente. Ainsi, le circuit d'éclairage est protégé contre le dysfonctionnement de cette diode électroluminescente. En cas de dysfonctionnement de la diode électroluminescente, si le circuit d'éclairage s'ouvre au niveau de cette diode électroluminescente, la diode Zener devient conductrice et permet au courant de contourner la diode électroluminescente qui ne fonctionne plus.

Selon un mode de réalisation, la diode Zener présente une tension de claquage supérieure d'au moins 5% à la tension d'alimentation de ladite diode électroluminescente avec laquelle elle est connectée directement en parallèle, de préférence supérieure de 5 à 15%.

Selon un mode de réalisation, une dite diode Zener, ou chaque ou certaines des diode(s) Zener, est connectée directement en parallèle à un ensemble de diodes électroluminescentes dont le nombre est compris entre 2 et 5. Ainsi, la diode Zener protège le circuit d'éclairage contre le dysfonctionnement de l'une des diodes électroluminescentes de cet ensemble. Le nombre de diodes Zener utilisé est en outre réduit.

Selon un mode de réalisation, la diode Zener présente une tension de claquage supérieure d'au moins 5% à la tension d'alimentation dudit ensemble de diodes électroluminescentes, de préférence supérieure de 5 à 15%.

De préférence, chaque diode électroluminescente est connectée en parallèle à l'une desdites diodes Zener.

Selon un mode de réalisation, ladite au moins une résistance montée en série avec ladite pluralité de diodes électroluminescentes comprend une pluralité de résistances réparties entre les diodes électroluminescentes de ladite pluralité de diodes électroluminescentes. Ainsi, la dissipation de l'énergie thermique produite par effet Joule dans les résistances est améliorée.

Selon un mode de réalisation, le circuit d'alimentation est réalisé sous la forme d'un module d'alimentation comportant une première carte de support et le circuit d'éclairage est réalisé sous la forme d'un module d'éclairage comportant une deuxième carte de support, le module d'éclairage comportant une entrée d'alimentation reliée à la sortie du circuit d'alimentation pour alimenter le circuit d'éclairage. Ainsi, le dispositif d'éclairage selon l'invention se présente sous une forme modulaire présentant deux modules.

Selon un mode de réalisation, le circuit d'alimentation est un premier circuit d'alimentation, le module d'éclairage est un premier module d'éclairage et le dispositif d'éclairage comporte un deuxième module d'éclairage relié à la sortie du circuit d'alimentation en parallèle dudit premier module d'éclairage, le deuxième module d'éclairage comprenant un deuxième circuit d'éclairage monté sur la au moins une carte de support et connecté à la sortie du circuit d'alimentation, le deuxième circuit d'éclairage comportant : une autre pluralité de diodes électroluminescentes montées en série, une autre pluralité de diodes Zener montées chacune en parallèle d'une ou plusieurs diodes électroluminescentes de l'autre pluralité de diodes électroluminescentes et au moins une autre résistance montée en série avec l'autre pluralité de diodes électroluminescentes, dans lequel une tension d'alimentation nominale cumulative de l'autre pluralité de diodes électroluminescentes montées en série est aussi adaptée à la tension efficace nominale du réseau électrique secteur.

Selon un mode de réalisation, le dispositif d'éclairage comprend en outre une batterie adaptée à être connectée au circuit d'éclairage de manière à alimenter ladite pluralité de diodes électroluminescentes ou un sous-ensemble de la pluralité de diodes électroluminescentes, le sous-ensemble comportant un nombre de diodes électroluminescentes strictement inférieur au nombre total de diodes électroluminescentes de ladite pluralité de diodes électroluminescentes. Ainsi, il est prévu une source d'alimentation autonome du dispositif d'éclairage en cas de défaillance du réseau électrique secteur. Le dispositif d'éclairage réalise ainsi une fonction d'éclairage de secours.

Selon un mode de réalisation, le circuit d'éclairage comporte une entrée intermédiaire adaptée à recevoir le courant continu délivré par la batterie, l'entrée intermédiaire étant connectée à un point intermédiaire de ladite pluralité de diodes électroluminescentes pour alimenter le sous-ensemble de la pluralité de diodes électroluminescentes.

Dans ce cas, la tension d'alimentation nominale cumulative du sous-ensemble de la pluralité de diodes électroluminescentes est de préférence adaptée à une tension nominale de la batterie. Ainsi, la batterie qui délivre une tension inférieure à celle délivrée par le réseau électrique peut alimenter le sous-ensemble de la pluralité de diodes électroluminescentes de manière satisfaisante.

**Brève description des figures**

L'invention sera mieux comprise, et d'autres buts, détails, caractéristiques et avantages de celle-ci apparaîtront plus clairement au cours de la description suivante de plusieurs modes de réalisation particuliers de l'invention, donnés uniquement à titre illustratif et non limitatif, en référence aux dessins annexés.

[Fig. 1] est une représentation schématique d'un premier mode de réalisation du dispositif d'éclairage.

[Fig. 2] est une représentation schématique d'un deuxième mode de réalisation du dispositif d'éclairage.

[Fig. 3] est une représentation schématique d'un premier exemple de réalisation d'un circuit d'alimentation convenant pour les dispositifs d'éclairage des figures 1 et 2.

[Fig. 4] est une représentation schématique d'un deuxième exemple de réalisation du circuit d'alimentation convenant pour les dispositifs d'éclairage des figures 1 et 2.

[Fig. 5] est une représentation schématique de la variation dans le temps de la tension secteur fournie en entrée des circuits d'alimentation des figures 3 et 4 et de la variation dans le temps correspondante de la tension délivrée en sortie de ces circuits d'alimentation.

[Fig. 6] est une représentation schématique d'un exemple de réalisation du circuit d'éclairage convenant pour les dispositifs d'éclairage des figures 1 et 2.

[Fig. 7] est une représentation schématique en coupe d'une carte de circuit imprimée pouvant être utilisée pour réaliser les dispositifs d'éclairage des figures 1 et 2.

[Fig. 8] est une représentation schématique en coupe d'une diode électroluminescente pouvant être utilisée dans le circuit d'éclairage de la figure 6.

## Description des modes de réalisation

On va décrire ci-dessous un dispositif d'éclairage 1 ; 2 pour éclairer un local exposé à un rayonnement ionisant.
Certains rayonnements sont dits ionisants car l'énergie qu'ils transportent est suffisante pour arracher des électrons aux atomes qu'ils traversent, formant ainsi des ions. Ce phénomène entraîne des modifications atomiques des matériaux exposés au rayonnement.
Il existe plusieurs types de rayonnements ionisants :

- le rayonnement alpha émis par un atome en perdant des protons et des neutrons,

- les rayonnements beta moins ou beta plus émis par un atome en transformant un neutron en proton ou vice-versa,

- les rayonnements X et gamma qui sont des émissions de photons à haute énergie.

Selon l'énergie transportée, les rayonnements ionisants pénètrent plus ou moins profondément dans les matériaux qu'ils rencontrent et sont plus ou moins susceptibles d'ioniser les atomes de ces matériaux.
Les rayonnements ionisants alpha et beta sont facilement arrêtés par un boîtier externe entourant le dispositif d'éclairage 1 ; 2 ou tout autre obstacle disposé entre la source du rayonnement et le dispositif d'éclairage 1 ; 2. Les rayonnement ionisants gamma ont en revanche une très longue portée (plusieurs centaines de mètres) et sont fortement pénétrants. Ils ne sont bloqués que par des épaisseurs importantes de matériaux denses tels que l'acier ou le béton. Ces rayonnements ionisants gamma ne sont pas bloqués par un boîtier externe entourant le dispositif d'éclairage. Le dispositif d'éclairage 1 ; 2 y sera donc exposé. Il en est de même pour les rayonnements X.
Les effets des rayonnements ionisants sur les matériaux sont de deux types :

- l'effet de dose ou cumulatif : les ions formés dans le matériau par le rayonnement ionisant entraînent un vieillissement prématuré du matériau en modifiant sa structure physique,

- l'effet singulier : les ions formés dans le matériau par le rayonnement ionisant créent un courant transitoire et parasite dans les composants électroniques jusqu'à leur destruction.

De nombreux matériaux voient ainsi leurs propriétés physiques, notamment mécaniques ou optiques, modifiées par l'exposition à un rayonnement ionisant. Les matériaux organiques sont particulièrement sensibles à ce type de rayonnement.
Le fonctionnement des composants électroniques est également dégradé par les rayonnements ionisants, jusqu'à les rendre éventuellement totalement inutilisables.
On mesure la dose de rayonnement ionisant physiquement « absorbée » par la matière en Gray, qui représente l'énergie absorbée par un kilogramme exposé à un rayonnement ionisant apportant une énergie d'1 joule : 1 Gy = 1 J/kg.
Les locaux exposés à des rayonnements ionisants sont notamment les locaux de centrales nucléaires ou de laboratoires de recherche tels que le CERN.

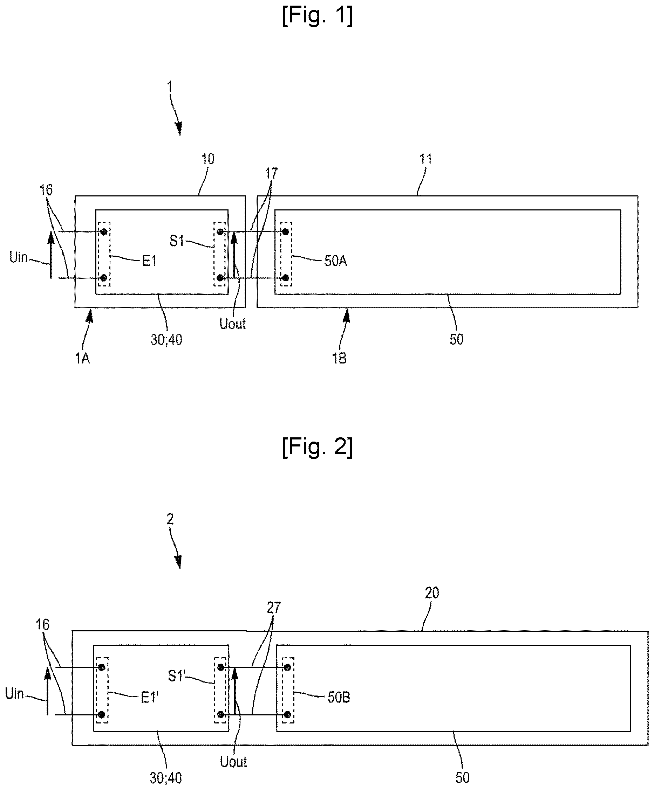

On a représenté de manière schématique deux modes de réalisation du dispositif d'éclairage sur les figures 1 et 2.

De manière générale, le dispositif d'éclairage 1 ou 2 comprend un circuit d'alimentation 30ou 40 et un circuit d'éclairage 50 et au moins une carte de support 10, 11 ; 20 sur laquelle ou lesquelles le circuit d'alimentation 30ou 40 et le circuit d'éclairage 50 sont montés.

Dans le premier mode de réalisation représenté sur la figure 1, le dispositif d'éclairage 1 comporte deux cartes de support 10 et 11, tandis que dans le deuxième mode de réalisation représenté sur la figure 2, le dispositif d'éclairage selon l'invention ne comporte qu'une seule carte de support 20.

Il est prévu par exemple autant de cartes de support que de circuits d'alimentation et de circuits d'éclairage.

Alors, comme cela est le cas dans le dispositif d'éclairage 1, le circuit d'alimentation 30 ou 40 est monté sur une première carte de support 10 et le circuit d'éclairage 50 est monté sur une deuxième carte de support 11, distincte et séparée de la première carte de support 10.

L'ensemble de la première carte de support 10 avec le circuit d'alimentation 30 ou 40 forme alors un module d'alimentation 1A et l'ensemble de la deuxième carte de support 11 avec le circuit d'éclairage 50 forme un module d'éclairage 1B.

Alternativement, comme cela est le cas dans le dispositif d'éclairage 2 représenté sur la figure 2, le circuit d'alimentation 30 ou 40 et le circuit d'éclairage 50 sont montés sur la même carte de support 20 unique.

En pratique, chaque carte de support se présente sous la forme une carte de circuit imprimé, qui sera décrite plus en détails plus loin.

Le circuit d'alimentation 30 ou 40 présente une entrée E1 ; E1' pour recevoir un courant alternatif d'un réseau secteur monophasé et une sortie S1 ; S1' adaptée à délivrer un courant continu en réponse à la réception du courant alternatif du réseau secteur monophasé.

L'entrée E1 ; E1' du circuit d'alimentation 30 ou 40 comprend en pratique des bornes de connexion adaptées à recevoir des fils électriques 16 ou des broches de connexion reliées au réseau secteur monophasé.

Dans le dispositif d'éclairage 1 représenté sur la figure 1, la sortie S1 du circuit d'alimentation 30 se présente sous la forme de bornes de connexion adaptés à recevoir des fils électriques 17 ou des broches de connexion pour la connexion du circuit d'alimentation 30 au circuit d'éclairage 50. Dans le dispositif d'éclairage 2 représenté sur la figure 2, la sortie S1' du circuit d'alimentation 40 fait partie de pistes conductrices 27 ménagées sur la carte de support 20 et qui connectent électriquement le circuit d'alimentation 40 et le circuit d'éclairage 50.

Le circuit d'alimentation 30 ou 40 comprend en outre un pont de diodes 33.

Le pont de diodes 33 est un assemblage de quatre diodes montées en pont qui redressent le courant alternatif monophasé en courant continu, c'est-à-dire ne circulant que dans un seul sens. Il s'agit plus particulièrement ici d'un pont redresseur double alternance. Le pont de diodes présente une tension d'alimentation nominale élevée, par exemple égale à la tension nominale du secteur. A la tension nominale, le pont de diodes est alimenté par un courant d'intensité faible, par exemple un courant nominal inférieur à 200 mA, par exemple environ 170 mA, ou un courant pic inférieur à 230 mA, ce qui limite l'échauffement du pont de diodes. Chaque diode du pont de diodes comporte par exemple une jonction p-n passivée au verre. Les quatre jonctions p-n passivées au verre du pont de diodes sont enfermées dans une enveloppe en matière plastique ou en verre. Le pont de diodes est adapté à recevoir un courant d'intensité supérieure au courant présent dans le circuit d'alimentation décrit. Par mesure de robustesse, chaque diode est par exemple adaptée à supporter 1000V ainsi qu'un courant nominal de 2 Ampères (A) et un courant pic de 50 A. Cela limite l'échauffement du pont de diodes et évite des contraintes supplémentaires sur l'enveloppe en matière plastique ou en verre de celui-ci. En outre, le pont de diodes est adapté à supporter un courant de surtension de crête élevé.

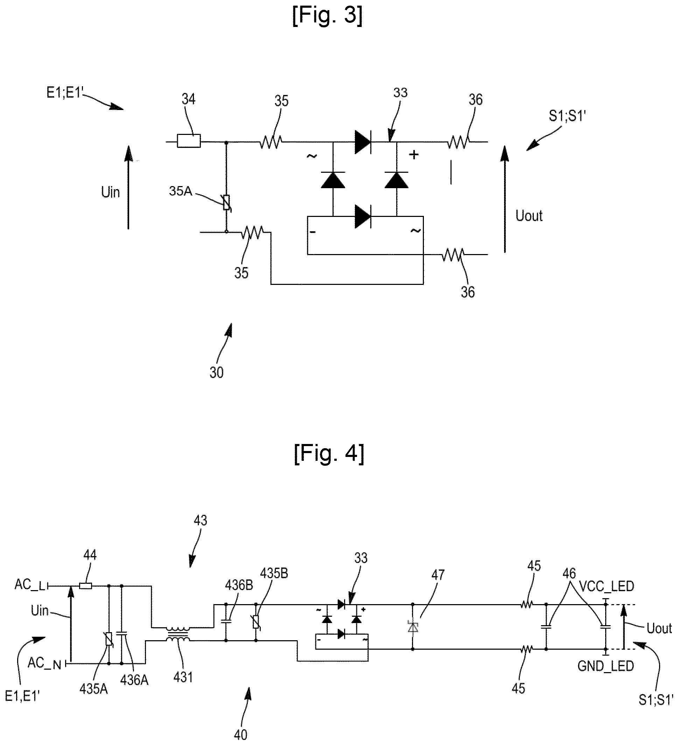

Selon un premier exemple de réalisation, représenté sur la figure 3, ledit circuit d'alimentation 30 est uniquement constitué du pont de diodes 33 et d'un ou plusieurs composants électriques sélectionnés parmi un fusible 34, une ou plusieurs varistance 35A et une ou plusieurs résistances35, 36.

Selon un deuxième exemple de réalisation représenté sur la figure 4, le circuit d'alimentation 40 comprend le pont de diodes 33, un fusible 44, des résistances 45, des condensateurs 46, des varistances 435A et 435B, des bobines 431, et une diode Transil 47. Il comprend en particulier un circuit de protection 43 contre les surtensions constitué des bobines 431, des condensateurs 436A, 436B, et des varistances 435A, 435B. De préférence, les bobines 431 constituent une self de mode commun du type « Common mode SSR coil » à haute impédance.

Le circuit d'alimentation 30 ou 40 ne comprend aucun transistor, aucun amplificateur opérationnel, aucun interrupteur et aucun circuit intégré. Le circuit d'alimentation est en outre réalisé sans transformateur de tension.

Ainsi, quel que soit l'exemple de réalisation du circuit d'alimentation 30ou 40, seuls des composants électriques peu sensibles aux rayonnements ionisants sont utilisés.

Dans le circuit d'alimentation 30 représenté sur la figure 3, celui-ci comporte le pont de diodes 33, un fusible 34, une varistance 35A et quatre résistances 35, 36. Les résistances 35, 36 sont connectées en série aux bornes d'entrée et de sortie du pont de diodes 33 (figure 3). La varistance 35A est disposée en parallèle du pont de diodes 33, en amont des résistances 35 située en amont du pont de diodes 33 et le fusible 34 est disposé en amont de la varistance 35A, en entrée du circuit. Ce premier mode de réalisation du circuit d'alimentation est simple et économique. Sa résistance aux surtensions transitoires rapides et élevées est limitée.

Le circuit d'alimentation 30 présente l'avantage de comporter un minimum de composants électriques.

Le fusible 34 protège le circuit d'alimentation en cas de surtensions importantes lorsque la varistance 35A commence à être endommagée. Le fusible 34 est par exemple un fusible à action retardée du type fusible à fils traversants. Il s'agit par exemple d'un fusible Bel Fuse ® de référence 0697H40000-02, entre 2 et 4 Ampères, par exemple à 4 Ampères. Le pont de diodes 33 est par exemple un pont de diodes Taiwan Semiconductor DBLS209G ®. Les résistances 35, 36 sont par exemple des résistances anti-surtension à film métallique (MELF) de 20 ohms.

Dans le circuit d'alimentation 40 (figure 4), il est prévu en entrée un fusible 44, puis le circuit de protection 43, le pont de diodes 33 monté en parallèle d'une diode Transil 47, deux résistances 45 et deux condensateurs 46 en parallèles à la sortie S1 ; S1' du circuit d'alimentation 40. Ce deuxième exemple de réalisation correspond à une version plus complexe du dispositif d'éclairage 1 ou 2.

Le fusible 44 protège le circuit d'alimentation en cas de surtensions importantes et en cas de court-circuit en fin de vie de la varistance ou du circuit imprimé.

Le circuit de protection 43 protège le dispositif d'éclairage 40 contre des pics de tension sur le réseau secteur monophasé.

En entrée et en sortie des bobines 431 sont disposés une varistance 435A, 435B et un condensateur 436A, 436B en parallèles l'un de l'autre.

On utilise des varistances pour protéger les diodes électroluminescentes 51 du circuit d'éclairage 50 contre les surtensions, notamment fortes et courtes et les décharges électrostatiques.

La self de mode commun a pour rôle de protéger la diode Transil 47 et la deuxième varistance 435B contre les courants élevés. Les surtensions élevées seront éliminées ou réduites grâce à la première varistance 435A en entrée. La deuxième varistance 435B protège les diodes électroluminescentes du circuit d'éclairage contre les surtensions. Les condensateurs 436A, 436B situés en amont et en aval du pont de diodes 33 sont destinés à améliorer le comportement en cas de décharge électrostatique (ESD) et à assurer une compatibilité électromagnétique (EMC) satisfaisante.

Le circuit de protection 43 peut également optionnellement comporter une ou plusieurs résistances en parallèle de la self de mode commun, à l'exclusion de tout autre composant électrique.

En combinaison avec le circuit de protection 43, la diode Transil 47 participe à la protection du circuit d'alimentation contre les décharges électrostatiques : elle protège contre les surtensions transitoires très rapides.

Les varistances 435A, 435B du circuit de protection 43 protègent contre des surtensions élevées plus longues que celles sur lesquelles agissent la diode Transil 47, par exemple dues à la foudre, et contre les surcharges. Les deux résistances 45 ont pour fonction de réduire le courant d'entrée des deux condensateurs 46. Il peut s'agir de varistances présentant une tension nominale comprise entre 387 et 473 V.

Les condensateurs 436A, 436B et 46 disposés avant et après le pont de diode 33 sont destinés à améliorer le comportement en cas de décharge électrostatique (ESD) et à assurer une compatibilité électromagnétique (EMC) satisfaisante.

Les condensateurs 46 disposés en parallèle à la sortie du circuit d'alimentation 40 sont optionnels. En variante, on peut envisager un circuit d'alimentation identique à celui de la figure 4, sans les condensateurs 46.

Lorsqu'ils sont présents, ces condensateurs 46 permettent de limiter le scintillement des diodes électroluminescentes. Ils permettent également de réduire le courant en sortie du circuit d'alimentation 40 en cas de surtensions pour protéger les diodes électroluminescentes du circuit d'éclairage 50 alimenté par le circuit d'alimentation 40.

Le fusible 44 est par exemple un fusible à action retardée du type fusible à fils traversants. Il s'agit par exemple d'un fusible Bel Fuse ® de référence 0697H40000-02, de 2 à 4 Ampères. Le pont de diodes 33 est par exemple un pont de diodes Taiwan Semiconductor DBLS209G ®. Les résistances sont par exemple des résistances anti-surtension à film métallique (MELF) de 20 ohms.

Les varistances 435A, 435B sont par exemple des varistances Ultramov de Littelfuse ® de référence V20E320P pour la première varistance 435A et V14E275P pour la deuxième varistance 435B ; les condensateurs sont par exemple de 0,1 microFarad et ont pour référence R523I310050P0K, 0,1 $\mu$F, 275V. Les bobines sont par exemple une self de mode commun Kemet SSR10H ® de 22 milliHenry. La diode Transil est par exemple une diode TVS Littelfuse SMCJ400A ®.

Le circuit l'alimentation 40 présente l'avantage d'être plus résistant aux pics de tension. Son utilisation permet l'obtention d'un éclairage plus stable et globalement de meilleure qualité.

Les condensateurs 46 assurent de meilleures performances d'éclairage, notamment en réduisant le scintillement des diodes électroluminescentes. Plus précisément, les deux condensateurs 46 réduisent le scintillement à la fréquence 100 Hz du courant électrique. Ils réduisent le temps d'extinction des diodes électroluminescentes à quelques millisecondes, ce qui améliore l'indice de scintillement du dispositif d'éclairage.

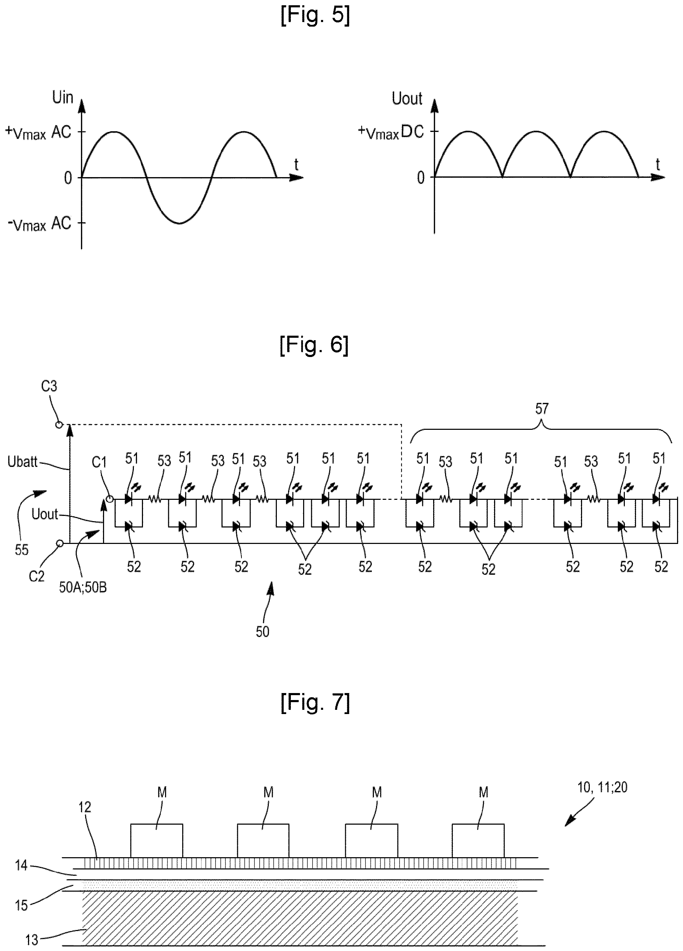

Le pont de diodes 33 permet d'effectuer un redressement double alternance comme cela est représenté schématiquement sur la figure 5.

La figure 5 montre sur le graphe de gauche la variation dans le temps de la tension alternative Uin du réseau secteur monophasé appliquée en entrée du circuit d'alimentation 30 ;40. Le graphe de droite sur la figure 5 montre schématiquement la variation dans le temps de la tension de sortie Uout du circuit d'alimentation 30 ou 40 alimenté par la tension alternative du graphe de droite. La tension de sortie Uout du circuit d'alimentation 30 ou 40 est une tension continue pulsée.

La fréquence de la tension alternative Uin est par exemple 50 Hz. La fréquence de la tension de sortie Uout est le double de la fréquence de la tension alternative Uin, ici par exemple 100Hz.

Le courant continu délivré par ledit circuit d'alimentation 30 ou 40 est un courant continu pulsé. Ce courant continu pulsé présente une tension de crête VmaxDC égale ou inférieure à une tension de crête VmaxAC du courant alternatif reçu en entrée du circuit d'alimentation. Ainsi, la tension de crête VmaxDC du courant continu pulsé est comprise par exemple entre 85 et 100% de la tension de crête VmaxAC du courant alternatif reçu en entrée du circuit d'alimentation, de préférence comprise entre 90 et 100 % de la tension de crête VmaxAC du courant alternatif reçu en entrée du circuit d'alimentation, c'est-à-dire entre 85 et 100%, de préférence entre 90 et 100% de la tension de crête du réseau secteur. La tension de sortie du circuit d'alimentation est appliquée en entrée du circuit d'éclairage : la tension de sortie du circuit d'alimentation est donc la tension d'alimentation du circuit d'éclairage.

Dans le dispositif d'éclairage 1 ou 2, le circuit d'éclairage 50 est alimenté par une tension haute, supérieure à 110V, et un courant faible, inférieur à 250mA, de préférence inférieur à 200mA.

En pratique, le circuit d'alimentation 30 ou 40 est destiné à être connecté à un réseau secteur monophasé présentant une tension efficace nominale supérieure ou égale à 110VAC, par exemple une tension efficace nominale égale à 230 VAC. La tension efficace réelle délivrée par le secteur est par exemple de préférence comprise entre la tension efficace nominale moins 15% et la tension efficace nominale du secteur plus 15%, par exemple ici entre 210 et 260 VAC, correspondant à une tension de crête comprise entre 296 et 364 V. Pour la tension efficace nominal du secteur égale à 230 VAC, la tension de crête est par exemple égale à 325V. Pour une utilisation avec un réseau secteur monophasé de 110V, le nombre de diodes électroluminescentes est réduit par rapport au nombre utilisé avec un secteur à 230 V.

Le circuit d'éclairage 50 est connecté à la sortie S1 ; S1' du circuit d'alimentation 30 ou 40.

A cet effet, dans le dispositif d'éclairage 1, le circuit d'éclairage 50 comporte des bornes de connexion 50A adaptés à recevoir les fils électriques 17 ou des broches de connexion pour la connexion du circuit d'éclairage 50 au circuit d'alimentation 30.

Dans le dispositif d'éclairage 2, le circuit d'éclairage 50 est connecté à la sortie S1' du circuit d'alimentation 40 par des pistes conductrices 50B ménagées sur la carte de support 20 et reliées aux pistes conductrices 27 dont fait partie la sortie S1' du circuit d'alimentation 40.

Le circuit d'éclairage 50 comprend :

- une pluralité de diodes électroluminescentes 51 montées en série,
- une pluralité de diodes Zener 52 montées chacune en parallèle d'une ou plusieurs diodes électroluminescentes 51 de la pluralité de diodes électroluminescentes 51 et
- des résistances 53 montées en série avec la pluralité de diodes électroluminescentes 51.

La chute de tension dans le circuit d'éclairage 50 résulte de la somme des chutes de tension aux bornes de tous les composants mis en série. On peut donc répartir la chute de tension dans le circuit d'éclairage 50 en une contribution de toutes les résistances 53 et une contribution de toutes les diodes électroluminescentes 51.

La contribution des diodes électroluminescentes 51 peut être déterminée à partir de la tension directe nominale de chacune. Cette tenson varie faiblement avec le courant. Une tension nominale cumulative de la pluralité de diodes électroluminescentes 51 montées en série est adaptée à une tension nominale du réseau secteur monophasé.

Le nombre de diodes électroluminescentes 51 et la tension nominale de chaque diode électroluminescente 51 sont déterminés que sorte que la tension nominale cumulative de la pluralité de diodes électroluminescentes est supérieure ou égale à 80 % de la tension nominale du réseau secteur, de préférence supérieure ou égale à 90% de la tension nominale du réseau secteur.

En outre, de préférence, la tension nominale cumulative de la pluralité de diodes électroluminescentes est inférieure ou égale à 120 % de la tension nominale du réseau secteur, de préférence inférieure ou égale à 100% de la tension nominale du réseau secteur.

La tension nominale du réseau secteur dont il est question est ici la tension efficace nominale de 230 V.

Pour sélectionner ces seuils, une marge de sécurité a été prise en compte car la tension du réseau secteur monophasé peut présenter des surtensions transitoires. Afin de rendre le circuit d'éclairage robuste vis-à-vis de ces surtensions, une surtension inférieure ou égale à 15 % de la tension nominale du réseau secteur monophasé a été prise en compte.

En ce qui concerne la tension d'alimentation nominale cumulative des diodes électroluminescentes, plus celle-ci est grande, et plus le circuit d'éclairage sera résistant aux surtensions. Cependant, la qualité d'éclairage sera moindre car le scintillement sera plus important (indice de scintillement plus élevé) que pour les diodes électroluminescentes de plus petite tension d'alimentation nominale cumulative.

C'est pourquoi, de préférence, la tension d'alimentation nominale cumulative de la pluralité de diodes électroluminescentes est inférieure ou égale à 120 % de la tension nominale du réseau secteur, de préférence inférieure ou égale à 100% de la tension nominale du réseau secteur.

Le choix de la tension nominale cumulative des diodes électroluminescentes et le dimensionnement des résistances associées dans le module d'éclairage résulte d'un compromis entre la tolérance aux instabilités du réseau électrique secteur, en particulier aux surtensions ponctuelles, et la qualité de l'éclairage.

. Comme pour le circuit d'alimentation seuls des composants électriques peu sensibles aux rayonnements ionisants sont utilisés dans le circuit d'éclairage 50.

De préférence, le circuit d'éclairage 50 est uniquement constitué de : la pluralité de diodes électroluminescentes 51 montées en série, la pluralité de diodes Zener 52 montées chacune en parallèle d'une ou plusieurs diodes électroluminescentes 51 de la pluralité de diodes électroluminescentes et la au moins une résistance 53 montée en série avec la pluralité de diodes électroluminescentes 51.

Un exemple d'un tel circuit d'éclairage 50 est représenté schématiquement sur la figure 6. La tension de sortie Uout du circuit d'alimentation 30 ; 40 est appliquée en entrée du circuit d'éclairage 50, entre un point d'entrée du circuit C1 et un point de sortie C2.

La tension d'alimentation du circuit d'éclairage 50 peut être ici supérieure ou égale à la tension nominale du réseau secteur monophasé. Elle est par exemple supérieure à la tension nominale du réseau lors de surtensions transitoires.

Le circuit d'éclairage 50 comporte de préférence plus de 50 diodes électroluminescentes. Il est prévu par exemple entre 65 et 80 diodes électroluminescentes 51.

Le courant nominal circulant dans chaque diode électroluminescente 51 est faible, de l'ordre de 50 à 250 mA, de préférence compris entre 50 et 200 mA. Ainsi, l'échauffement des diodes électroluminescentes 51 est limité. Le courant nominal traversant chaque diode électroluminescente reste de préférence inférieur à 250mA de préférence inférieur à 240 mA, de préférence inférieur ou égale à 200mA, par exemple égale à 120mA. Le courant pic peut être plus élevé lors de surtensions transitoires.

Les résistances 53 connectées en série aux diodes électroluminescentes 51 ont pour rôle de dissiper de l'énergie sous forme de chaleur et de limiter le courant traversant les diodes électroluminescentes 51.

On peut prévoir des groupes de deux résistances 53 en parallèles pour maintenir le fonctionnement du circuit d'éclairage 50 lorsque l'une des deux résistances en parallèles est endommagée.

La résistance équivalente totale de l'ensemble des résistances 53 réduit le courant en cas de surtensions transitoires. L'intensité crête du courant reste de préférence inférieure à l'intensité maximale du courant pouvant traverser chaque diode électroluminescente.

Le choix de la résistance équivalente totale de l'ensemble des résistances 53 est un compromis entre la robustesse du circuit d'éclairage 50 aux surtensions d'une part, et son efficacité énergétique d'autre part.

Exemple 1

Le circuit d'alimentation 40 représenté à la figure 4 est utilisé et la tension efficace nominale du secteur est égale à 230VAC, ce qui correspond à une tension de crête d'environ 325V. La tension de sortie Uout du circuit d'alimentation 40 présente une tension de crête d'environ 320 V, soit 98% de la tension crête du secteur. Il est prévu une pluralité de résistance 53 réparties entre les diodes électroluminescentes 51 dont la résistance globale équivalente est comprise entre 500 et 1200 ohms. Il peut être prévu ici 35 groupes de deux résistances 53 de 33 ohms (correspondant à 500mW) chacune disposées en parallèle l'une de l'autre et en série des diodes électroluminescentes 51. La résistance équivalente de l'ensemble des résistances du circuit d'éclairage 50 est alors égale à 577 ohms. Le circuit d'éclairage 50 comprend alors ici 75 diodes électroluminescentes 51. Les diodes électroluminescentes sont par exemple des diodes de référence Nichia NE2B757GT_B1 ou NVSLE21A ®. Leurs tensions directes nominales sont données dans le tableau 1.

La tension d'alimentation nominale cumulée de l'ensemble des diodes électroluminescentes est par exemple égale à 210V au courant nominal de 200mA.

L'utilisation de 75 diodes électroluminescentes telles que décrites ci-dessus est adaptée lorsque la tension secteur nominale est égale à 230V. Ce nombre sera réduit si la tension secteur nominale utilisée est plus basse que 230V, par exemple égale à 110VAC.

Dans cet exemple, chaque diode électroluminescente 51 est disposée en parallèle d'une unique diode Zener et chaque diode Zener est disposée en parallèles d'une unique diode électroluminescente 51.

Tableau 1 : tensions directes des diodes électroluminescentes

| Référence LED | $U_{F, min}$ (V) | $U_{F, max}$ (V) |
|---|---|---|
| Nichia ® NE2B757GT_B1 | 2,5 | 3,3 |
| Seoul ® SZ8Y22 | 2,6 | 3,05 |
| Nichia® NVS E21A | 2,8 | 3,0 |
| Nichia® NFSL757 GT | 2,4 | 3,3 |
| Nichia® NVSL219 CT | 2,6 | 3,4 |
| Seoul ® Z5M4-SZ5 | 2,55 | 3,0 |

Exemple 2

En variante on peut également prévoir 68 résistances de 33 ohms réparties entre les diodes électroluminescentes en 34 groupes de deux résistances en parallèle. La résistance équivalente de l'ensemble des résistances du circuit d'éclairage 50 est alors égale à 561 ohms. Le circuit d'éclairage 50 comprend alors ici 75 diodes électroluminescentes 51de référence Seoul SZ8Y22 ®.

Dans cet exemple, chaque diode électroluminescente est disposée en parallèle d'une unique diode Zener et chaque diode Zener est disposée en parallèle d'une unique diode électroluminescente 51. Les diodes électroluminescentes de l'exemple 1 (Nichia®) sont moulées dans du plastique. Celles de l'exemple 2 (Seoul®) sont entièrement en céramique. La différence réside dans la possibilité d'un courant maximal plus élevé et d'une meilleure stabilité dans l'exemple 2. Par exemple, les diodes électroluminescentes des exemples 1 et 2 ont des intensités maximales de courant différentes : les diodes électroluminescentes Nichia ® de l'exemple 1 ont une intensité maximale de 250mA et celle de l'exemple 2 (Seoul®) ont une intensité maximale de courant de 2,0A. Une autre différence réside dans le rendement lumineux : les LED de puissance moyenne comme celle de l'exemple 1 ont un rendement lumineux amélioré qui peut être supérieur à 60%. Le choix des diodes électroluminescentes dépend de la chaleur maximale et de la tension d'entrée maximale par rapport à une plus grande efficacité et une plus petite stabilité. Les diodes en céramique ont une plus grande résistance aux radiations et une durée de vie plus longue, mais un coût supérieur.

En variante, il est possible de distribuer diversement les composants résistifs en fonction de l'environnement et en particulier de sa capacité à dissiper la chaleur produite par le circuit. Par exemple il est possible d'utiliser une seule résistance d'environ 560 ohms par exemple ou un nombre inférieur de résistance ayant des valeurs plus grandes que 33 ohms comme dans les exemples donnés ci-dessus. Il est possible d'utiliser également un nombre plus grand de résistances ayant des valeurs plus petites que l'exemple décrit ci-dessus. Il est avantageux que le dispositif d'éclairage 1 ; 2 compte un plus grand nombre de résistances de plus petite valeur pour permettre une meilleure dissipation de l'énergie thermique produite par effet Joule dans ces résistances.

On peut prévoir par exemple un nombre de résistances au moins égal au quart ou à la moitié du nombre de diodes électroluminescentes 51, de préférence compris entre le quart du nombre de diodes électroluminescentes et le nombre de diodes électroluminescentes.

En outre, il est utile d'augmenter le nombre de résistances prévue en série des diodes électroluminescentes dans le circuit d'éclairage 50 lorsqu'il est destiné à fonctionner avec un réseau électrique secteur moins stable, ce qui implique que les variations de la tension d'alimentation du circuit d'éclairage augmentent.

Sur l'exemple représenté sur la figure 6, chaque diode Zener 52 du circuit d'éclairage 50 du dispositif d'éclairage est connectée directement en parallèle à une unique diode électroluminescente 51.

En variante, une dite diode Zener 52, ici chaque diode Zener, est connectée directement en parallèle à un ensemble de diodes électroluminescentes dont le nombre est compris entre 2 et 5.

Chaque diode Zener 52 est conçue pour commencer à conduire le courant électrique en réponse à une tension électrique supérieure à une valeur seuil appelée tension de claquage. Elle joue le rôle d'un interrupteur commandé par la tension qui lui est appliquée.

Chaque diode Zener 52 présente ici une tension de claquage supérieure d'au moins 5% à la tension d'alimentation dudit ensemble de diodes électroluminescentes, de préférence supérieure de 5 à 15%.

Par exemple, la tension d'alimentation nominale de chaque diode électroluminescente 51 est comprise entre 2,8 et 3,3V et la tension de claquage de chaque diode Zener 52 disposée en parallèle d'une seule diode électroluminescente 51 est comprise entre 3,4 et 3,8 V, par exemple égale à 3,5V.

Ainsi, en réponse à la défaillance d'une desdites diodes électroluminescentes 51, l'ouverture du circuit d'éclairage 50 au niveau de la diode électroluminescente 51 défaillante entraîne l'application d'une tension supérieure ou égale à la tension de claquage aux bornes de la diode Zener 52 disposée en parallèle de la diode électroluminescente défaillante. La diode Zener 52 correspondante devient conductrice et permet au courant de passer. La diode Zener 52 permet au courant de contourner la diode électroluminescente défaillante.

Cela permet au circuit d'éclairage 50 de continuer à fonctionner, même lorsqu'une ou plusieurs diodes est défaillante et ouvre le circuit d'éclairage 50.

Le circuit d'alimentation 30 ; 40 et le circuit d'éclairage 50 sont adaptés à résister sans perte de fonctionnalité à une dose de rayonnement ionisant supérieure à 5000 gray (Gy), de préférence supérieure à 10000 Gy, de préférence supérieure à 20000 Gy, de préférence supérieure à 50000 Gy, de préférence supérieure à 100000 Gy, de préférence supérieure à 250 kGy.

On entend par « résister sans perte de fonctionnalité » le fait que le dispositif d'éclairage émet, après irradiation, un flux lumineux sensiblement égal au flux lumineux émis avant irradiation.

De manière générale, le dispositif d'éclairage 1 ; 2 est exempt de composant électrique particulièrement sensible aux rayonnements ionisants.

En particulier, le dispositif d'éclairage 1 ; 2 est exempt de transistors, d'amplificateur opérationnel, d'interrupteur et de tout circuit intégré. Le circuit d'alimentation est réalisé sans transformateur de tension, ce qui évite d'employer des bobines classiques de transformateur de tension, dont la gaine isolante est susceptible d'être vulnérable au rayonnement ionisant et de causer un court-circuit qui entrainerait une fin de vie prématurée du circuit d'alimentation.

Chaque composant électrique utilisé est sélectionné pour présenter une résistance aux rayonnements ionisants optimisée.

De manière générale, des composants électriques de grandes tailles, encombrants, sont sélectionnés. Il s'agit de préférence de composants électriques discrets, non intégrés, non miniaturisés. Le dispositif d'éclairage 1 ; 2 est exempt de tout composant électrique intégré ou miniature ou comportant une électronique de commande. Dans chaque famille de composants électriques, résistances, condensateurs, diodes etc, les composants de plus grande taille compatibles avec leur utilisation dans le dispositif d'éclairage sont choisis.

En outre, l'utilisation des matériaux organiques tels que plastiques, polymères, silicone, est limitée. Les composants électriques du dispositif d'éclairage 1 ; 2 sont faits de matériaux aussi peu sensibles que possible aux effets des rayonnements ionisants.

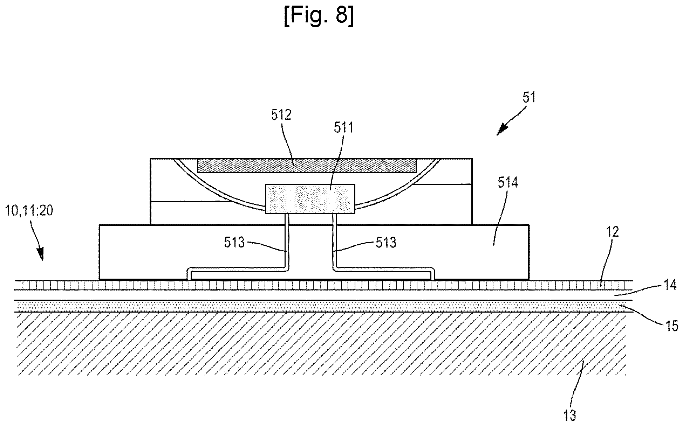

En particulier, chaque diode électroluminescente 51 de ladite pluralité de diodes électroluminescentes 51 comprend un élément semi-conducteur 511 et un luminophore 512 montés sur une plaque support 514, comme représenté par exemple sur la figure 8. L'élément semi-conducteur 511 émet une lumière bleue à une longueur d'onde d'environ 450 nm lorsque traversé par le courant électrique. Le luminophore éclairé par cette lumière bleue émet une lumière jaune qui se mélange à la lumière bleue pour donner une lumière sensiblement blanche.

Cet élément semi-conducteur 511 et le luminophore 512 sont ou non recouverts d'une lentille optique.

De préférence, chaque diode électroluminescente 51 est exempt de lentille optique, comme dans l'exemple représenté sur la figure 8. La lentille optique est en effet généralement réalisée en silicone et risque de s'opacifier ou s'assombrir en réponse à l'exposition aux rayonnements ionisants.

En outre, la lumière émise par la diode électroluminescente sans lentille est moins directionnelle qu'en présence de la lentille optique. En pratique, la diode électroluminescentes émet dans un cône d'émission d'angle au sommet égal à 160° ; contre 60 à 120° en présence de la lentille optique.

Chaque diode Zener 52 est de préférence du type comprenant un boîtier 521 en verre inorganique, sans utilisation de matériau plastique ou polymère. En variante, les diodes Zener peuvent également comprendre un boîtier en matière plastique ou polymère.

De manière générale, les diodes Zener sont des composants de puissance avec des structures relativement grandes favorisant une stabilité des matériaux. La diode Zener 52 équipée d'un boîtier 521 en verre présente en outre une résistance aux rayonnements ionisants plus grande qu'une autre diode Zener comprenant un boîtier en matériau plastique ou polymère. On utilise de préférence des diodes Zener à jonction passivée au verre qui sont stables et robustes. L'utilisation d'autres types de diodes utilisant une plaque en silicone et de la colle risque d'entraîner des défaillances plus nombreuses liées à un décalage entre la colle et la plaque silicone.

La carte de support 10, 11 ou 20 est une carte de circuit imprimé dont une vue schématique en coupe est représentée sur la figure 7. Elle comporte une couche de matériau conducteur électrique 12 et une structure porteuse 13.

La couche de matériau conducteur électrique 12 est par exemple une couche de cuivre ou un autre métal présentant de préférence un conductivité électrique supérieure à $20 \times 10^6$ S/m à 20 °C. Elle présente de préférence une épaisseur supérieure à 50 micromètres mesure par exemple entre 50 et 150 micromètres d'épaisseur, par exemple 70 micromètres.

Dans cette couche de matériau conducteur sont aménagées les pistes conductrices du circuit imprimé. Les pistes conductrices sont par exemple obtenues par photolithographie.

La structure porteuse 13 se présente par exemple sous la forme d'une plaque rectangulaire. Elle est réalisée dans l'un des matériaux suivants : aluminium, cuivre, composite de résine époxyde renforcé en fibre de verre, résine epoxy, céramique. Il s'agit par exemple d'une plaque d'aluminium. L'épaisseur de la plaque formant la structure porteuse est par exemple égale à 2 millimètres.

La structure porteuse est avantageusement réalisée dans un matériau présentant une conductivité thermique élevée afin d'évacuer rapidement la chaleur et réduire la température des diodes électroluminescentes afin d'éviter un vieillissement prématuré de celles-ci. En outre, l'échauffement des diodes électroluminescentes 51 est limité grâce au courant faible les traversant.

Dans les dispositifs d'éclairage 1 et 2 pour lesquels la structure porteuse est réalisé dans un matériau conducteur de l'électricité (aluminium ou cuivre), la carte de circuit imprimé comporte en outre une couche de matériau isolant 14 interposée entre la couche de matériau conducteur 12 et la structure porteuse 13. Sur l'exemple de la figure 7, la couche de matériau isolant 14 est collée sur la structure porteuse 13 par une couche de colle 15. Cette couche de colle 15 mesure par exemple entre 20 et 50 micromètres d'épaisseur. On entend ici par matériau isolant un matériau isolant électriquement.

La couche de matériau isolant 14 est par exemple un matériau diélectrique réalisé en céramique, comprenant par exemple des fibres céramiques. Elle mesure par exemple entre 50 et 100 micromètres d'épaisseur.

L'épaisseur de la couche de matériau isolant et le matériau isolant utilisé sont déterminés en tenant compte d'un compromis entre isolation électrique efficace et isolation thermique limitée. En effet, la carte de circuit imprimé présente de préférence des propriétés de dissipation de la chaleur afin de dissiper la chaleur produite par les diodes électroluminescentes 51 et les résistances 53 lors du passage du courant. Le matériau de la structure porteuse présente donc de préférence une conductivité thermique optimisée, de préférence supérieure à $3Wm^{-1}K^{-1}$. L'épaisseur de la couche de matériau isolant est supérieure à 90 $\mu$m pour éviter les défaillances dans l'environnement ionisant. L'épaisseur de la couche de matériau isolant 14 est par exemple égale à 100 $\mu$m.

Les diodes électroluminescentes 51, les diodes Zener 52 et les résistances 53 sont par exemple soudées sur la couche en matériau conducteur 12. La figure 7 montre des composants électriques génériques M soudés sur la couche en matériau conducteur 12 qui peuvent être des diodes électroluminescentes 51, des diodes Zener 52 ou des résistances 53.

Comme cela est visible sur la figure 8, chaque diode électroluminescente 51 comporte deux fils électriques de connexion 513 connectant l'élément semi-conducteur 511 à la couche en matériau conducteur 12 de la carte de circuit imprimé formant la carte support 10, 11 ; 20. Ils sont ainsi connectés électriquement aux pistes conductrices du circuit imprimé.

En variante encore, on peut prévoir plusieurs couches de matériau conducteur séparées par des couches de matériaux isolants électriquement. Ces couches de matériau conducteur séparées par des couches de matériau isolant forment une face avant du circuit imprimé. Les couches de matériau isolant présentent de préférence une épaisseur supérieure à 90 $\mu$m. La face arrière est formée par une couche de métal tel que l'aluminium.

Selon une variante non représentée, le circuit d'éclairage décrit précédemment est un premier circuit d'éclairage et le dispositif d'éclairage selon l'invention comporte un deuxième circuit d'éclairage connecté audit circuit d'alimentation tel que décrit précédemment, en parallèle dudit premier circuit d'éclairage.

Le deuxième circuit d'éclairage est similaire au premier: il comporte une autre pluralité de diodes électroluminescentes montées en série, une autre pluralité de diodes Zener montées chacune en parallèle d'une ou plusieurs diodes électroluminescentes de l'autre pluralité de diodes électroluminescentes et au moins une autre résistance montée en série avec l'autre pluralité de diodes électroluminescentes, une tension nominale cumulative de l'autre pluralité de diodes électroluminescentes montées en série étant adaptée à la tension de crête du courant alternatif du réseau secteur monophasé.

Dans le cas du mode de réalisation de la figure 1, il est prévu par exemple un deuxième module d'éclairage relié à la sortie du circuit d'alimentation en parallèle d'un premier module d'éclairage comportant ledit premier circuit d'éclairage. Le deuxième module d'éclairage est par exemple identique au premier module d'éclairage.

Dans le cas du mode de réalisation de la figure 2, le deuxième circuit d'éclairage est supporté par la même carte support. Le deuxième circuit d'éclairage est par exemple identique au premier circuit d'éclairage.

En variante, le deuxième circuit d'éclairage diffère du premier circuit d'éclairage, par exemple par le type de diodes électroluminescentes utilisées. Les diodes électroluminescentes du deuxième circuit d'éclairage émettent par exemple une lumière de couleur différente de la lumière émise par les diodes électroluminescentes du premier circuit.

On peut par exemple envisager l'utilisation de diodes électroluminescentes produisant une lumière blanche ou jaune.

Selon un mode de réalisation, le dispositif d'éclairage comporte en outre une batterie (non représentée) adaptée à être connectée au circuit d'éclairage 50.

La batterie délivre par exemple une tension continue de 120 V.

Dans ce cas, chaque diode électroluminescente 51 est alimentée par une tension inférieure à sa tension d'alimentation nominale et émettra un flux lumineux inférieur au flux lumineux obtenu par une alimentation avec la tension d'alimentation nominale.

En variante, la batterie peut être adaptée à être connectée au circuit d'éclairage 50 de manière à alimenter un sous-ensemble 57 des diodes électroluminescentes 51 du circuit d'éclairage 50 (figure 6).

Le nombre de diodes électroluminescentes du sous-ensemble 57 est adapté à la tension continue délivrée par la batterie.

En pratique, le nombre de diodes électroluminescentes 51 du sous-ensemble 57 est déterminé pour que la tension d'alimentation nominale cumulative des diodes électroluminescentes de ce sous-groupe 57 soit supérieure ou égale à 80 % de la tension appliquée aux bornes du circuit d'éclairage 50, de préférence supérieure ou égale à 90% de la tension appliquée aux bornes du circuit d'éclairage 50. En conséquence, le nombre de diodes électroluminescentes 51 du sous-ensemble 57 est déterminé pour que la tension d'alimentation nominale cumulative des diodes électroluminescentes de ce sous-groupe 57 soit supérieure ou égale à 80%, de préférence 85 ou 90%, de la tension continue délivrée par la batterie.

En outre, le nombre de diodes électroluminescentes 51 du sous-ensemble 57 est déterminé pour que la tension d'alimentation nominale cumulative des diodes électroluminescentes de ce sous-groupe 57 soit inférieure ou égale à 120%, de préférence 115 ou 100%, de la tension continue délivrée par la batterie.

Comme cela est représenté schématiquement sur la figure 6, le circuit d'éclairage 50 comporte alors à cet effet une entrée intermédiaire C3 adaptée à recevoir le courant continu Ubatt délivré par la batterie, l'entrée intermédiaire C3 étant située entre deux diodes électroluminescentes 51 de manière à alimenter ledit sous-ensemble 57 en contournant le reste des diodes électroluminescentes 51.

En outre, le circuit d'alimentation 30 ou 40 et le circuit d'éclairage 50 du dispositif d'éclairage 1 ou 2 ne présente pas de distorsion harmonique. Le facteur de puissance du dispositif d'éclairage peut être supérieur à 85%, par exemple compris entre 90 et 99%.

Des tests d'irradiation conduits par la demanderesse ont montré la résistance du dispositif d'éclairage selon l'invention à l'irradiation par rayonnements ionisants.

Le dispositif d'éclairage 1 a été testé.

Le module d'alimentation comportant le circuit d'alimentation 30 et le module d'alimentation comportant le circuit d'alimentation 40 ont été irradiés ainsi que le module d'éclairage 50 réalisé avec différents modèles commerciaux de diodes électroluminescentes 51.

Les conditions de l'irradiation étaient les suivantes.

Les modules d'alimentation et d'éclairage ont été exposés à 1 m de la source de rayonnement, à un champ de rayonnement X jusqu'à 3 MeV.

Les essais sont réalisés dans les conditions normales de température, pression et hygrométrie. L'irradiation est interrompue à 10 reprises pour respecter des paliers et vérifier le fonctionnement de certains modules à chaque palier de dose d'irradiation.

Des dosimètres de référence (pastilles Alanine) sont disposés en plusieurs points des équipements afin de déterminer la cartographie de la dose avec une incertitude relative élargie de 3,4 %.

Les conditions de température, pression et hygrométrie durant l'ensemble des essais ont été telles que :

- 18,4 °C < T < 18,6 °C

- 995,8 hPa < P < 1014,5 hPa

- 64,1 % < H < 70,0 %.

Les résultats sont les suivant.

Le module d'alimentation 1A comportant le circuit d'alimentation 30 présente toujours un fonctionnement sans défaut après une dose absorbée réelle de 6040 Gy correspondant à une dose émise par la source de rayonnement X de 10000 Gy. L'irradiation a été réalisée sur deux modules d'alimentation non connectés au réseau secteur alternatif et sur deux modules d'alimentation connectés au réseau. Les résultats sont identiques pour les quatre modules conformes au premier mode de réalisation.

Le module d'alimentation 1A comportant le circuit d'alimentation 40 présente toujours un fonctionnement sans défaut après une dose absorbée réelle de 6040 Gy correspondant à une dose émise par la source de rayonnement X de 10000 Gy. L'irradiation a été réalisée sur trois modules d'alimentation non connectés au réseau secteur alternatif et sur un quatrième module d'alimentation connectés au réseau. Les résultats sont identiques pour les quatre modules d'alimentation.

Le module d'éclairage 1B comportant le circuit d'éclairage 50 conforme à l'exemple de réalisation décrit ci-dessus présente toujours un fonctionnement sans défaut après une dose absorbée réelle d'environ 8,8 kiloGray (kGy) correspondant à une dose émise par la source de rayonnement X de 10000 Gy. L'irradiation a été réalisé sur différents modules d'éclairage non alimentés, réalisés avec différents modèles de diodes électroluminescentes :

- un module d'éclairage muni de 75 diodes électroluminescentes Nichia ® de référence NVS E21A ;

-   un module d'éclairage muni de 75 diodes électroluminescentes Nichia ® de référence NFSL757 GT ;

-   un module d'éclairage muni de 75 diodes électroluminescentes Nichia ® de référence NVSL219 CT ;

-   un module d'éclairage muni de 75 diodes électroluminescentes Samsung ® de référence LM281B Plus ;

-   un module d'éclairage muni de 75 diodes électroluminescentes Seoul ® de référence Z5M4-SZ5 ;

-   un module d'éclairage muni de 75 diodes électroluminescentes Seoul ® de référence Y22.

Les diodes Zener utilisées sont ici de référence BZT55C6V6, de voltage 3,6V produites par Taiwan Semiconductor. Les résistances du circuit d'alimentation sont des résistances de 33 Ohms, de référence 33RCRCW120633ROFKEAHP, commercialisées par Vishay®. Les résistances du circuit d'éclairage sont des résistances de 20 Ohms, de référence 20RCMB02070X2009GB200, commercialisées par Vishay®. Après l'irradiation, chaque module d'éclairage testé est branché sur un module d'alimentation alimenté par le secteur et le fonctionnement des diodes électroluminescentes est vérifié. Tous les modules d'éclairage testés présentent un fonctionnement sans défaut après la dose réelle absorbée de 8,8 kGy.

Une dose de 8,8 kGy est réputée correspondre à la dose de rayonnement ionisant maximale reçue par un équipement passant 10 ans dans une zone fortement irradiée d'un bâtiment réacteur d'une centrale nucléaire. Cette zone est couramment dénommée « zone inaccessible » du bâtiment réacteur

Le dispositif d'éclairage selon l'invention est donc particulièrement adapté à une utilisation dans ce contexte.

Bien que l'invention ait été décrite en liaison avec plusieurs modes de réalisation particuliers, il est bien évident qu'elle n'y est nullement limitée et qu'elle comprend tous les équivalents techniques des moyens décrits ainsi que leurs combinaisons si celles-ci entrent dans le cadre de l'invention.

L'usage du verbe « comporter », « comprendre » ou « inclure » et de ses formes conjuguées n'exclut pas la présence d'autres éléments ou d'autres étapes que ceux énoncés dans une revendication.

Dans les revendications, tout signe de référence entre parenthèses ne saurait être interprété comme une limitation de la revendication.

**Revendications**

1.  [Dispositif d'éclairage (1 ; 2) pour éclairer un local exposé à un rayonnement ionisant, comportant :

    au moins une carte de support (10, 11 ; 20),
    un circuit d'alimentation (30 ; 40) monté sur la au moins une carte de support (10, 11 ; 20), le circuit d'alimentation (30 ; 40) présentant une entrée (E1) pour recevoir un courant alternatif d'un réseau électrique secteur et une sortie (S1) adaptée à délivrer un courant continu en réponse à la réception du courant alternatif, le circuit d'alimentation ( 30 ; 40) comprenant un pont de diodes (33) , et
    un circuit d'éclairage (50) monté sur la au moins une carte de support (11 ; 20) et connecté à la sortie (S1) du circuit d'alimentation, le circuit d'éclairage (50) comportant :

    une pluralité de diodes électroluminescentes (51) montées en série,
    une pluralité de diodes Zener (52) montées chacune en parallèle d'une ou plusieurs diodes électroluminescentes (51) de la pluralité de diodes électroluminescentes (51) et
    au moins une résistance (53) montée en série avec la pluralité de diodes électroluminescentes (51),
    dans lequel une tension d'alimentation nominale cumulative de la pluralité de diodes électroluminescentes montées en série est adaptée à une tension nominale du réseau électrique secteur.

2.  Dispositif d'éclairage selon la revendication 1, dans lequel la tension d'alimentation nominale cumulative de la pluralité de diodes électroluminescentes est supérieure ou égale à 80 % de la tension efficace nominale du réseau électrique secteur et inférieure ou égale à 120 % de la tension efficace nominale du réseau électrique secteur.

3.  Dispositif d'éclairage selon l'une des revendications 1 et 2, dans lequel le courant continu délivré par ledit circuit d'alimentation (30 ; 40) est un courant continu pulsé qui présente une tension de crête comprise entre 85 et 100% de la tension de crête du courant alternatif du réseau électrique secteur reçu en entrée du circuit d'alimentation (30 ; 40).

4.  Dispositif d'éclairage selon l'une des revendications 1 à 3, dans lequel circuit d'alimentation (30 ; 40) ne comporte aucun transformateur de tension.

5. Dispositif d'éclairage selon l'une des revendications 1 à 4, dans lequel le circuit d'alimentation (30 ; 40) est destiné à être connecté à un réseau électrique secteur monophasé présentant une tension efficace nominale supérieure à 110VAC.

6. Dispositif selon l'une des revendications 1 à 5, dans lequel le circuit d'alimentation (30 ; 40) et le circuit d'éclairage (50) sont adaptés à résister sans perte de fonctionnalité à une dose de rayonnement ionisant supérieure ou égale à 8,8 kilogray (kGy).

7. Dispositif d'éclairage selon l'une des revendications 1 à 6, dans lequel ledit circuit d'alimentation (30) est uniquement constitué du pont de diodes (33) et d'un ou plusieurs composants électriques sélectionnés parmi : un fusible (34) et des résistances (35, 36).

8. Dispositif d'éclairage selon l'une des revendications 1 à 6, dans lequel ledit circuit d'alimentation (40) comprend un circuit de protection (43) contre les surtensions, le circuit de protection (43) contre les surtensions étant uniquement constitué d'un ou plusieurs composants électriques sélectionnés parmi : une ou plusieurs bobines de fil conducteur (431), un ou plusieurs condensateurs (436A, 436B), et une ou plusieurs varistances (435A, 435B).

9. Dispositif d'éclairage selon l'une des revendications 1 à 8, dans lequel la au moins une carte de support (10, 11 ; 20) est une carte de circuit imprimé comportant une couche de matériau conducteur électrique (12) et une structure porteuse (13), dans laquelle la structure porteuse (13) est réalisée dans un ou plusieurs matériaux choisis parmi : aluminium, cuivre, composite de résine époxyde renforcé en fibre de verre, résine epoxy, céramique.

10. Dispositif d'éclairage selon l'une des revendications 1 à 9, dans lequel une dite diode électroluminescente (51) de ladite pluralité de diodes électroluminescentes (51) comprend un élément semi-conducteur (511) et un luminophore (512), non recouverts d'une lentille optique.

11. Dispositif d'éclairage selon l'une des revendications 1 à 10, dans lequel une dite diode électroluminescente (51) de ladite pluralité de diodes électroluminescentes (51) présente une tension directe nominale supérieure à 2V, de préférence comprise entre 2,7 et 3V pour un courant de 200 mA, et dans lequel le circuit d'éclairage comporte plus de 50 diodes électroluminescentes (51).

12. Dispositif d'éclairage selon l'une des revendications 1 à 11, dans lequel une dite diode Zener (52) est du type comprenant un boîtier en verre inorganique, sans utilisation de matériau plastique, de matériau polymère ou de silicone.

13. Dispositif d'éclairage selon l'une des revendications 1 à 12, dans lequel une dite diode Zener (52) est connectée directement en parallèle à une dite diode électroluminescente (51).

14. Dispositif d'éclairage selon la revendication 13, dans lequel chaque diode Zener (52) présente une tension de claquage supérieure d'au moins 5% à la tension directe nominale de la diode électroluminescente, de préférence supérieure de 5 à 15%.

15. Dispositif d'éclairage selon l'une des revendications 1 à 14, dans lequel ladite au moins une résistance montée en série avec ladite pluralité de diodes électroluminescentes (51) comprend une pluralité de résistances (53) réparties entre les diodes électroluminescentes (51) de ladite pluralité de diodes électroluminescentes (51).

16. Dispositif d'éclairage selon l'une des revendications 1 à 15, dans lequel le circuit d'alimentation (30 ; 40) est réalisé sous la forme d'un module d'alimentation (1A) comportant une première carte de support (10) et le circuit d'éclairage (50) est réalisé sous la forme d'un module d'éclairage (1B) comportant une deuxième carte de support (11), le module d'éclairage (1B) comportant une entrée d'alimentation (50A) reliée à la sortie (S1) du circuit d'alimentation (30 ; 40) pour alimenter le circuit d'éclairage (50).

17. Dispositif d'éclairage selon l'une des revendications 1 à 16, comprenant en outre une batterie adaptée à être connectée au circuit d'éclairage de manière à alimenter ladite pluralité de diodes électroluminescentes (51) ou un sous-ensemble (57) de la pluralité de diodes électroluminescentes (51), le sous-ensemble (57) comportant un nombre de diodes électroluminescentes (51) strictement inférieur au nombre total de diodes électroluminescentes (51) de ladite pluralité de diodes électroluminescentes (51).

18. Dispositif d'éclairage selon la revendication 17, dans lequel le circuit d'éclairage (50) comporte une entrée intermédiaire (55) adaptée à recevoir le courant continu délivré par la batterie, l'entrée intermédiaire (55) étant connectée à un point intermédiaire de ladite pluralité de diodes électroluminescentes (51) pour alimenter le sous-ensemble (57) de la pluralité de diodes électroluminescentes (51).

[Fig. 1]

[Fig. 2]

[Fig. 3]

[Fig. 4]

[Fig. 5]

[Fig. 6]

[Fig. 7]

[Fig. 8]

Europäisches
Patentamt

European
Patent Office

Office européen
des brevets

## RAPPORT DE RECHERCHE EUROPEENNE

**Numéro de la demande**

EP 24 30 5218

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2008/101383 A1 (SHENZHEN UNIBERO TECHNOLOGY CO [CN]; XIAO XIANGBAI [CN]) 28 août 2008 (2008-08-28) * alinéa [0033]; revendication 19; figure 4 * * alinéa [0039] - alinéa [0043] * ----- | 1-12, 15-18 | INV. H05B45/37 H05B45/48 |
| X | WO 2014/012274 A1 (ZHANG ZHIJUN [CN]) 23 janvier 2014 (2014-01-23) * figure 3 * * alinéa [0018] * * alinéa [0041] - alinéa [0042] * ----- | 1,4,5,7, 13-15 | |
| X | KR 100 867 361 B1 (KIM YONG CHUL [KR]) 6 novembre 2008 (2008-11-06) * figure 1 * * page 2 * ----- | 1,4,7,8, 13 | |

**DOMAINES TECHNIQUES RECHERCHES (IPC)**

H05B

Le présent rapport a été établi pour toutes les revendications

| Lieu de la recherche | Date d'achèvement de la recherche | Examinateur |
|---|---|---|
| Munich | 11 juin 2024 | Alberti, Carine |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.............................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 24 30 5218

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

11-06-2024

| Document brevet cité au rapport de recherche | Date de publication | Membre(s) de la famille de brevet(s) | Date de publication |
|---|---|---|---|
| WO 2008101383 A1 | 28-08-2008 | CN 101018437 A | 15-08-2007 |
| | | WO 2008101383 A1 | 28-08-2008 |
| WO 2014012274 A1 | 23-01-2014 | CN 102821516 A | 12-12-2012 |
| | | WO 2014012274 A1 | 23-01-2014 |
| KR 100867361 B1 | 06-11-2008 | KR 100867361 B1 | 06-11-2008 |
| | | WO 2010002199 A2 | 07-01-2010 |

EPO FORM P0460

Pour tout renseignement concernant cette annexe : voir Journal Officiel de l'Office européen des brevets, No.12/82

**EP 4 601 416 A1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CN 114143932 A
- CN 112867197 A
- CN 109219183 A